# EUROPEAN PATENT APPLICATION

(11) **EP 4 841 658 A1**
(43) Date of publication of application: **18.11.2026**
(21) Application number: 26178216.3
(22) Date of filing: 12.05.2026
(51) Int. Cl.: H01C 7/06, G01R 1/20, H01C 1/14, H01C 1/148, H01C 17/232, H01C 1/144

(54) **RESISTOR WITH ADJUSTABLE TEMPERATURE COEFFICIENT OF RESISTANCE**

(30) Priority: 14.05.2025 US 202563805425 P
(71) Applicant: CYNTEC CO., LTD., Hsinchu 30076 (TW)
(72) Inventor: HUANG, Rihyang, Hsinchu 30076 (TW); CHUANG, Yu hsuan, Hsinchu 30076 (TW); WANG, Yu-min, Hsinchu 30076 (TW); CHOU, Po kuei, Hsinchu 30076 (TW); CHANG, Hao-chun, Hsinchu 30076 (TW)
(74) Representative: von Bülow & Tamada

(57) **Abstract**

A resistor includes: a first conductive sheet defining a first groove, the first conductive sheet defining a bottom surface of the first groove, such that the first groove does not penetrate the first conductive sheet; a second conductive sheet defining a second groove, the second conductive sheet defining a bottom surface of the second groove, such that the second groove does not penetrate the second conductive sheet; and a resistive sheet disposed between the first and second conductive sheets. A first detection point and a second detection point are respectively formed on the first and second conductive sheets.

## Description

### BACKGROUND OF THE INVENTION

### FIELD OF THE INVENTION

This invention relates to a resistor, and more particularly to a resistor whose temperature coefficient of resistance can be adjusted during the manufacturing process.

### DESCRIPTION OF THE PRIOR ART

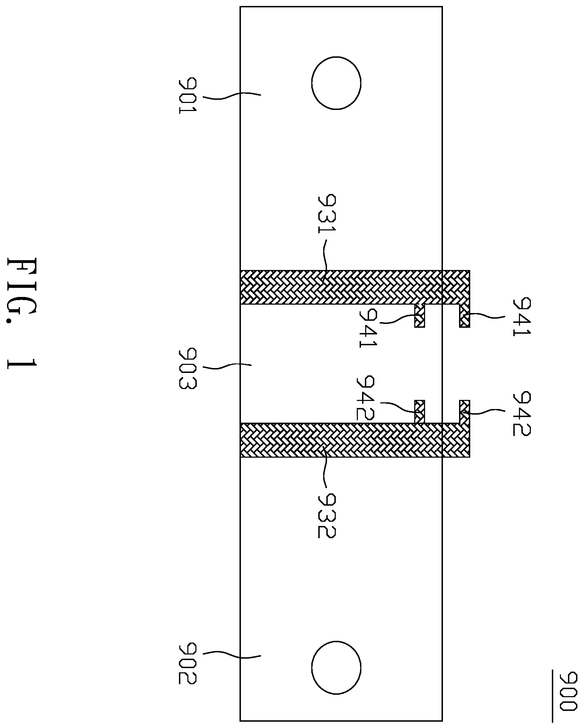

FIG. 1 is a top view of a resistor according to the prior art. As shown in FIG. 1, the prior art resistor 900 includes a first conductive sheet 901, a second conductive sheet 902, and a resistive sheet 903 disposed between the first conductive sheet 901 and the second conductive sheet 902. The resistor 900 further includes a first sampling line 931 and a second sampling line 932. The first sampling line 931 is attached to the first conductive sheet 901 and extends outward from an upper edge of the first conductive sheet 901. The second sampling line 932 is attached to the second conductive sheet 902 and extends outward from an upper edge of the second conductive sheet 902. The first sampling line 931 includes two first opposing portions 941 extending from the first sampling line 931 toward the second sampling line 932. The second sampling line 932 includes two second opposing portions 942 extending from the second sampling line 932 toward the first sampling line 931.

Currently, shunt resistors are widely adopted for current sensing procedures in electric vehicles. By detecting the voltage drop across the shunt as current flows through its two terminals, and applying Ohm's law (V = IR) with the shunt's known resistance value, the actual current value can be calculated. Shunt resistors are typically composed of conductive sheets (e.g., pure copper) joined with a resistive alloy (e.g., Cu-Mn-Sn or Cu-Mn-Ni). While pure copper has a high Temperature Coefficient of Resistance (TCR) of approximately 3900 ppm/K, the TCR of the resistive alloy is near zero. However, as current flows through the shunt, the operating temperature increases, causing the TCR to increase due to the influence of the pure copper terminals. For instance, with a shunt's TCR of 100 ppm/K, a 50°C rise in operating temperature without compensation would lead to a 0.5% resistance deviation, thereby increasing current measurement error.

To address the errors caused by temperature rise, current techniques typically involve pre-characterizing the TCR curve of the shunt. A temperature sensing element (such as a thermistor) is used to obtain the operating temperature. The resistance is then compensated based on the TCR curve and the operating temperature. Current technology can limit the TCR error within ±20 ppm/K. However, for dynamic currents (such as instantaneous high-current surges generated in a short period), due to the slow thermal response time of the thermistor, it is unable to provide real-time error correction, leading to inaccurate current measurements.

To overcome the aforementioned problems, prior art, such as US Patent No. 8,198,977 B2, discloses a resistor with temperature coefficient of resistance (TCR) compensation. The primary technical approach involves forming a calibration through-slot that extends through the upper and lower surfaces of the conductive terminal. This modifies the current path, thereby suppressing variations in the overall TCR.

### SUMMARY OF THE INVENTION

The primary objective of an embodiment of the present invention is to provide a resistor with an adjustable temperature coefficient of resistance (TCR). Another objective is to actively adjust the temperature difference and current path between sampling points through structural configuration, thereby enhancing the precision of resistance calibration.

A first embodiment of the present invention provides a resistor comprising: a first conductive sheet defining a first groove, wherein the first conductive sheet forms a bottom surface of the first groove such that the first groove does not penetrate the first conductive sheet (or is configured as a non-through groove); a second conductive sheet defining a second groove, wherein the second conductive sheet forms a bottom surface of the second groove such that the second groove does not penetrate the second conductive sheet (or is configured as a non-through groove); and a resistive sheet disposed between the first and second conductive sheets. A first detection point and a second detection point are respectively formed on the first and second conductive sheets.

In one embodiment, the first conductive sheet is plate-shaped. The first groove is a rectangular groove and comprises: a first longitudinal side (b) extending along a first direction from the first conductive sheet toward the second conductive sheet; a first transverse side (a) extending along a second direction perpendicular to the first direction; and a first vertical side (c) recessed inward from the surface of the first conductive sheet and perpendicular to the first and second directions. In another embodiment, preferably, the second conductive sheet is plate-shaped. The second groove is a rectangular groove and comprises: a second longitudinal side (e) extending along the first direction; a second transverse side (d) extending along the second direction; and a second vertical side (f) recessed inward from the surface of the second conductive sheet and perpendicular to the first and second directions.

In one embodiment, the width of the first transverse side is denoted as a, the length of the first longitudinal side is denoted as b, and the depth of the first vertical side is denoted as c, wherein a > b > c. In a preferred embodiment, the width of the second transverse side is denoted as d, the length of the second longitudinal side is denoted as e, and the depth of the second vertical side is denoted as f, wherein d > e > f. In another preferred embodiment, the width of the first transverse side is denoted as a, the length of the first longitudinal side is denoted as b, the depth of the first vertical side is denoted as c, the width of the second transverse side is denoted as d, the length of the second longitudinal side is denoted as e, and the depth of the second vertical side is denoted as f, wherein a = d, b = e, and f ≠ c.

In one embodiment, the first groove is formed recessed inward from the first surface of the first conductive sheet, such that the first conductive sheet has a smaller effective conductive cross-section at the location of the first groove compared to the locations of remaining portions of the first conductive sheet. The second groove is formed recessed inward from the first surface of the second conductive sheet, such that the second conductive sheet has a smaller effective conductive cross-section at the location of the second groove compared to the locations of remaining portions of the second conductive sheet. Furthermore, the first detection point and the second detection point are located between the first groove and the second groove.

A second embodiment of the present invention provides a resistor comprising a first conductive sheet; a second conductive sheet; a resistive sheet disposed between the first and second conductive sheets; a first extension portion protruding from a first side of the first conductive sheet; a second extension portion protruding from a first side of the second conductive sheet, wherein the protrusion direction of the second extension portion is the same as that of the first extension portion; a first detection point electrically connected to the first extension portion; and a second detection point electrically connected to the second extension portion. In a preferred embodiment, the resistive sheet further extends between the first extension portion and the second extension portion.

In one embodiment, the first conductive sheet is plate-shaped. The first extension portion is rectangular and comprises: a first longitudinal side (a1) extending along a first direction from the first conductive sheet toward the second conductive sheet; and a first transverse side (h1) extending along a second direction perpendicular to the first direction. The second conductive sheet is plate-shaped, and the second extension portion is rectangular and includes: a second longitudinal side (b1) extending along the first direction from the first conductive sheet toward the second conductive sheet; and a second transverse side (h2) extending along a second direction perpendicular to the first direction.

In one embodiment, the length of the first longitudinal side is denoted as a1, the length of the second longitudinal side is denoted as b1, the width of the first transverse side is denoted as h1, and the width of the second transverse side is denoted as h2, wherein h1 = h2. The width of the first conductive sheet is denoted as Y1, and the width of the second conductive sheet is denoted as Y2, wherein Y1 = Y2 and h1 < Y1. In a preferred embodiment, when current flows from the first conductive sheet toward the second conductive sheet, the relationship a1 < b1 is established.

In one embodiment, the resistor further comprises: a first sampling line attached to the first conductive sheet and extending to the first extension portion, and adjacent to the resistive sheet; and a second sampling line attached to the second conductive sheet and extending to the second extension portion, and adjacent to the resistive sheet. The first sampling line comprises a first protruding portion extending from the side of the first sampling line proximate to the resistive sheet and further protruding beyond the first extension portion, and the first protruding portion serves as the first detection point. The second sampling line comprises a second protruding portion extending from the side of the second sampling line proximate to the resistive sheet and further protruding beyond the second extension portion, and the second protruding portion serves as the second detection point.

In one embodiment, the first sampling line comprises: a first protruding portion extending outward from the side of the first sampling line proximate to the resistive sheet, and further protruding beyond the first extension portion; and a first opposing portion extending from a free end of the first protruding portion toward the second protruding portion, wherein the first opposing portion serves as the first detection point. The second sampling line comprises: a second protruding portion extending outward from the side of the second sampling line proximate to the resistive sheet, and further protruding beyond the second extension portion; and a second opposing portion extending from a free end of the second protruding portion toward the first protruding portion, wherein the second opposing portion serves as the second detection point.

In one embodiment, the resistor further comprises an assembled circuit board. The assembled circuit board is disposed on the first sampling line and the second sampling line and is electrically connected to the first detection point and the second detection point. The assembled circuit board defines an opening, the position of which corresponds to a portion of the resistive sheet so as to expose the resistive sheet, wherein the exposed portion of the resistive sheet is cut to form a trimming cut for resistance adjustment.

In one embodiment, no protruding portion is formed on the side of the first sampling line away from the resistive sheet, and no protruding portion is formed on the side of the second sampling line away from the resistive sheet.

An embodiment of the present invention provides a resistor with an adjustable temperature coefficient of resistance (TCR), wherein grooves or extension portions serving as volume-structure modifying features are formed on conductive sheets to actively adjust a current path between sampling points while simultaneously adjusting a temperature difference, thereby enhancing the precision of current measurement.

### BRIEF DESCRIPTION OF THE DRAWINGS

The disclosure is illustrated by embodiments, depicted by accompanying drawings, and described below. The accompanying drawings are not drawn to scale, depending on standards accepted in related art. For the sake of clear illustration, the dimensions of parts and components shown in the accompanying drawings may be increased or decreased as desired.
FIG. 1 is a top view of a resistor according to the prior art.
FIG. 2A is a top view of a resistor according to an embodiment of the present invention.
FIG. 2B is a perspective view of a resistor according to an embodiment of the present invention.
FIG. 2C is a top view of a resistor according to another embodiment of the present invention.
FIG. 3A is a curve diagram showing relationships between groove depths and TCR values under different temperatures.
FIG. 3B is a curve diagram showing relationships between groove widths and TCR values under different temperatures.
FIG. 4 is a top view of a resistor according to another embodiment of the present invention.
FIG. 5 is a curve diagram showing the relationship between longitudinal side lengths and TCR values based on experimental data of the embodiment of FIG. 4.
FIG. 6 is a top view of a resistor according to another embodiment of the present invention.
FIG. 7 is a top view of a resistor according to another embodiment of the present invention.

### DETAILED DESCRIPTION OF THE EMBODIMENTS

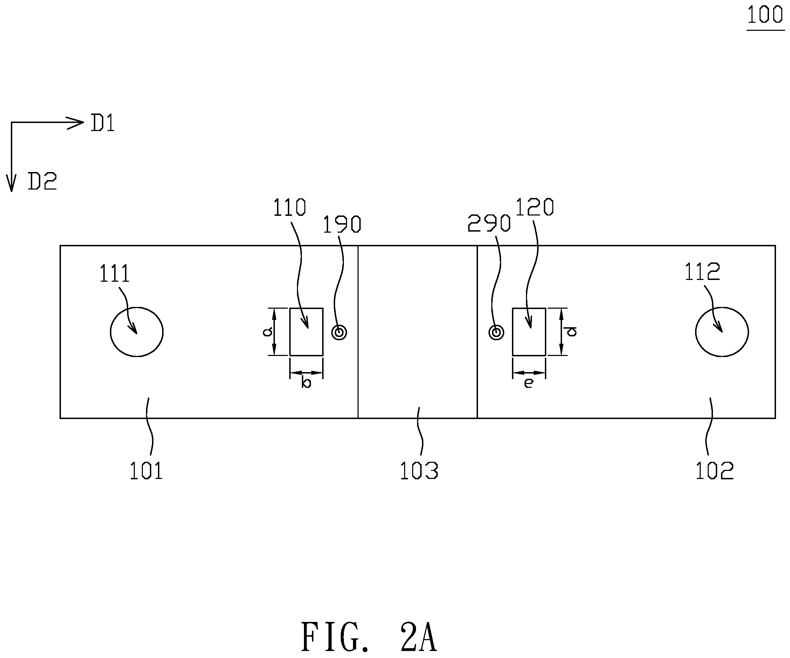

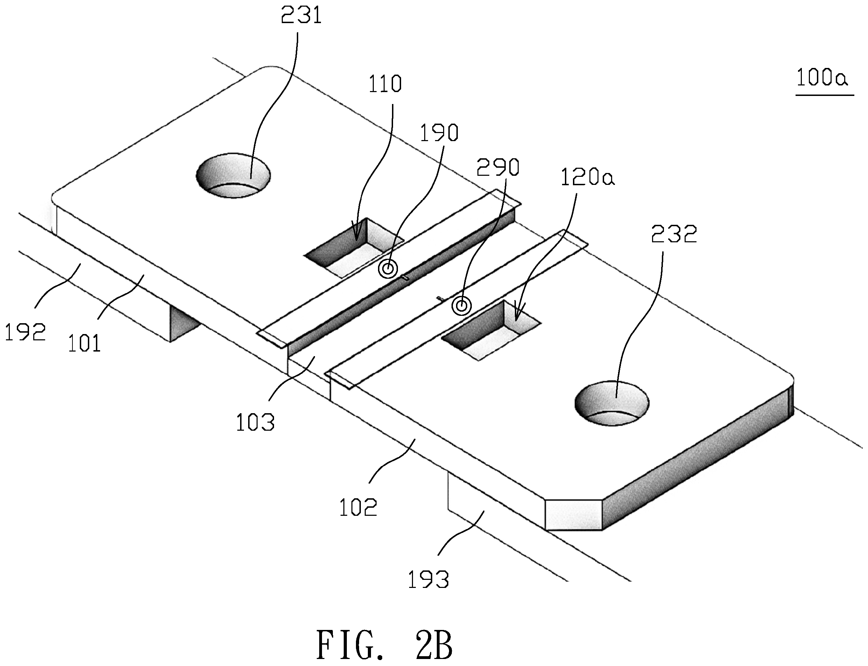

FIG. 2A is a top view of a resistor according to an embodiment of the present invention. FIG. 2B is a perspective view of a resistor according to an embodiment of the present invention. As shown in FIGS. 2A and 2B, according to an embodiment of the present invention, a resistor 100 is provided, which is a shunt resistor having an adjustable temperature coefficient of resistance. The resistor 100 comprises a first conductive sheet 101, a second conductive sheet 102, and a resistive sheet 103 disposed between the first conductive sheet 101 and the second conductive sheet 102. The first conductive sheet 101 and the second conductive sheet 102 may be made of copper, aluminum, or an alloy combination thereof. The resistive sheet 103 may be made of copper-manganese-tin alloy, copper-manganese-nickel alloy, nickel-chromium-aluminum-silicon alloy, or an alloy combination thereof. Preferably, the resistance value of the resistive sheet 103 is greater than the resistance values of the first conductive sheet 101 and the second conductive sheet 102, and more preferably at least 10 times greater.

The resistor 100 defines a main current direction D1, which is designated as a first direction extending from the first conductive sheet 101 toward the second conductive sheet 102 and corresponding to a primary current flow direction. A width direction corresponding to a transverse direction of the conductive sheets is designated as a second direction D2, and the second direction D2 is perpendicular to the first direction D1.

In one embodiment of the present invention, the first conductive sheet 101 is plate-shaped and preferably substantially rectangular, and defines a first groove 110. The first conductive sheet 101 further defines a bottom surface of the first groove 110 such that the first groove 110 is configured as a non-through groove that does not penetrate the first conductive sheet 101. Similarly, the second conductive sheet 102 is also plate-shaped and preferably substantially rectangular, and defines a second groove 120. The second conductive sheet 102 further defines a bottom surface of the second groove 120 such that the second groove 120 is configured as a non-through groove that does not penetrate the second conductive sheet 102. The first groove 110 is formed recessed inward from a first surface (upper surface) of the first conductive sheet 101, such that the first conductive sheet 101 has a smaller effective conductive cross-section at the location of the first groove 110 compared to the locations of remaining portions of the first conductive sheet 101. Similarly, the second groove 120 is formed recessed inward from a first surface (upper surface) of the second conductive sheet 102, such that the second conductive sheet 102 has a smaller effective conductive cross-section at the location of the second groove 120, compared to the locations of remaining portions of the second conductive sheet. It should be noted that, in other embodiments, a plurality of first grooves 110 and second grooves 120 may be provided.

In one embodiment, the first groove 110 and the second groove 120 may be rectangular grooves. The first groove 110 comprises: a first longitudinal side extending along the first direction (with a length denoted as b); a first transverse side extending along the second direction (with a width denoted as a); and a first vertical side recessed inward from the first surface of the first conductive sheet 101 and perpendicular to the first and second directions (with a depth denoted as c). Similarly, the second groove 120 comprises: a second longitudinal side extending along the first direction (with a length denoted as e); a second transverse side extending along the second direction (with a width denoted as d); and a second vertical side recessed inward from the first surface of the second conductive sheet 102 and perpendicular to the first and second directions (with a depth denoted as f).

Regarding the dimensions of the grooves, in a preferred embodiment, a > b > c is satisfied, and in a more preferred embodiment, d > e > f is further satisfied. In one embodiment, the top-view dimensions of the first groove 110 and the second groove 120 may correspond to or be identical to each other, satisfying a = d and b = e, while the depths thereof may be different (f ≠ c), for example, f > c. In one embodiment, if the thicknesses of the first conductive sheet 101 and the second conductive sheet 102 are equal and denoted as h, the following conditions are satisfied: h > c, h > f, h - c > 0, and h - f > 1 mm, wherein the thickness difference indicates that a remaining thickness of the conductive sheet at a bottom portion of the groove is greater than 1 mm.

The resistor 100 further comprises a first detection point 190 and a second detection point 290. The first detection point 190 is formed on the first conductive sheet 101 and is located on a side of the first groove 110 proximate to the resistive sheet 103. The second detection point 290 is formed on the second conductive sheet 102 and is located on a side of the second groove 120 proximate to the resistive sheet 103. More specifically, the first detection point 190 and the second detection point 290 are both located between the first groove 110 and the second groove 120. In other words, on a projection plane having the first direction D1 as a normal direction, the first detection point 190 and the second detection point 290 are located within projected spans of the first groove 110 and the second groove 120.

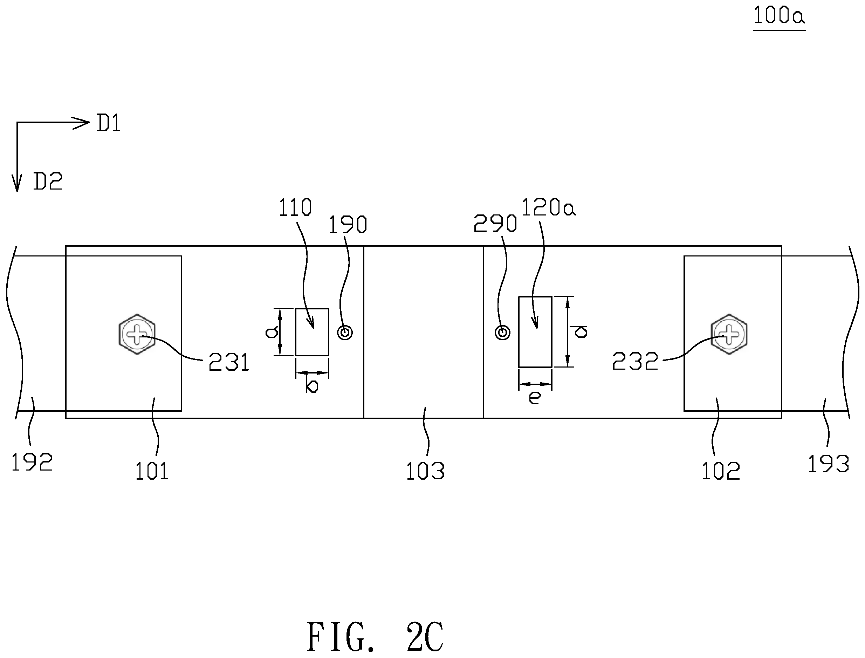

FIG. 2C is a top view of a resistor according to an embodiment of the present invention. The embodiment of FIG. 2C is similar to the embodiment of FIG. 2A. Therefore, identical elements are denoted by the same reference numerals, and related descriptions thereof are omitted. Only at least one difference therebetween is described below. As shown in FIG. 2C, the first groove 110 and the second groove 120a have different planar dimensions. For example, the width (a) of the first transverse side of the first groove 110 and the width (d) of the second transverse side of the second groove 120a satisfy the relationship of a < d, and the lengths of the longitudinal sides thereof satisfy the relationship of b = e.

In one embodiment, the first conductive sheet 101 is formed with a first locking hole 111, and the second conductive sheet 102 is formed with a second locking hole 112. Corresponding fastening elements 231, 232 (such as screws) may be respectively inserted into the first locking hole 111 and the second locking hole 112 of the resistor 100, so as to secure the resistor 100 within a battery module. When power conductive bars (bus bars) or conductive wires 192 and 193 (in a battery or on a current path of a power system) are fastened to the first conductive sheet 101 and/or the second conductive sheet 102 through the above-mentioned screws extending through the first locking hole 111 and the second locking hole 112, the power conductive bar or conductive wire 192 may establish stable surface contact with the first conductive sheet 101, and the power conductive bar or conductive wire 193 may establish stable surface contact with the second conductive sheet 102. This fastening configuration provides enhanced fastening mechanical strength for the connection between the resistor 100 and an external circuit.

The primary purpose of such an asymmetric groove dimension structure is to actively regulate a temperature difference between terminals of the resistor 100, 100a and sampling points thereof. Specifically, in an actual application environment of a shunt resistor, two sides of the resistor 100 may exhibit a temperature difference due to different heat dissipation efficiencies (for example, one side being adjacent to an external heat source). Such temperature difference may induce an electromotive force (EMF), thereby causing errors in current measurement. In the resistor 100a of the present embodiment, by adjusting a dimensional difference between the first groove 110 and the second groove 120a, a compensating temperature difference may be actively generated between two terminals of the resistor 100a. The compensating temperature difference is configured to offset the temperature difference originally caused by the external heat source between the two terminals, thereby significantly reducing an influence of the electromotive force (EMF) on measurement accuracy.

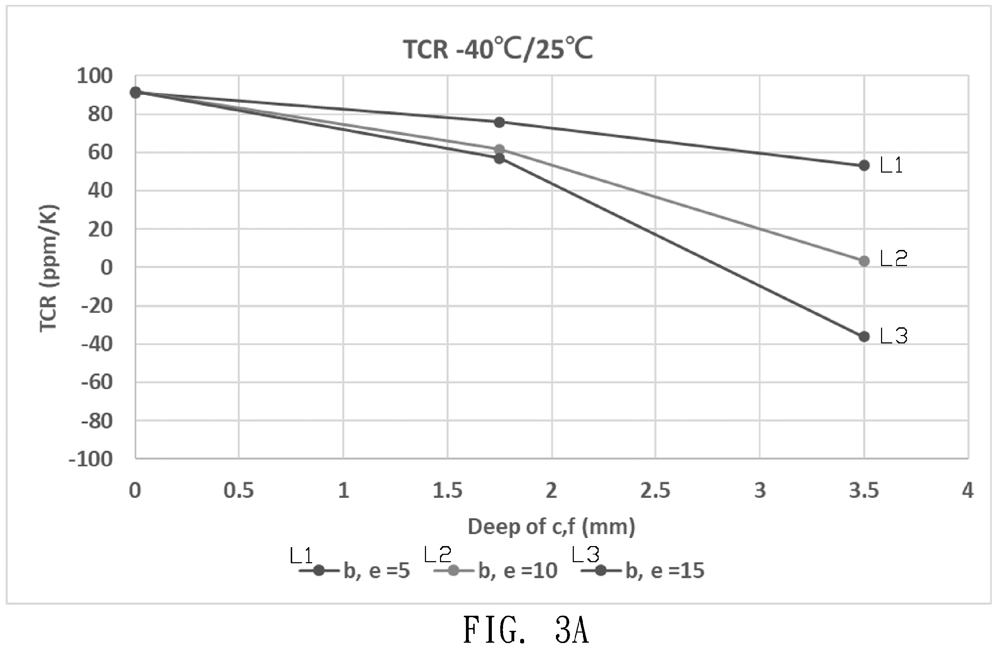

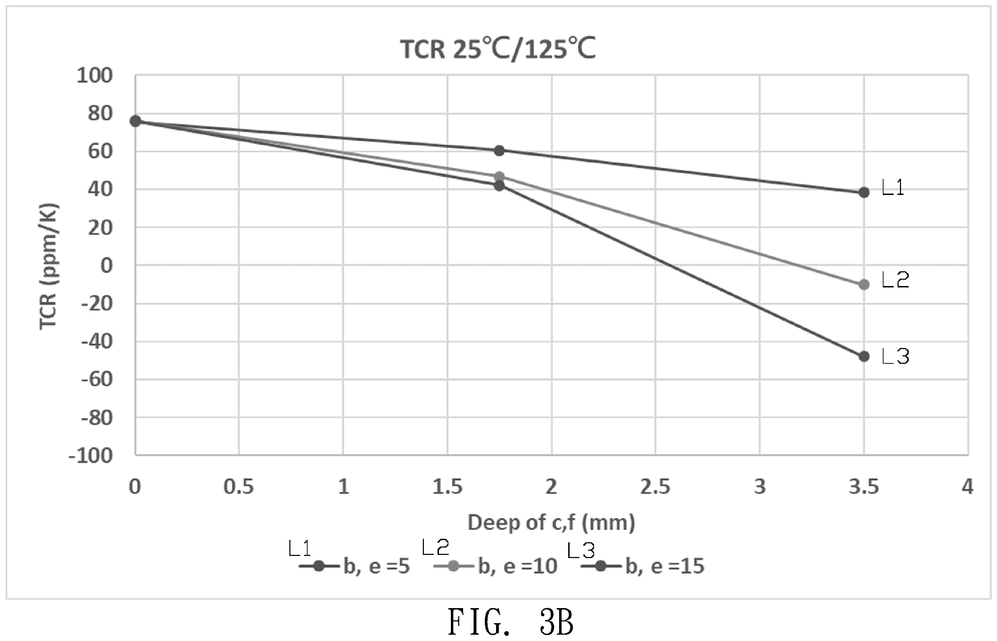

FIG. 3A is a curve diagram showing relationships between groove depths and TCR values under different temperatures. FIG. 3B is a curve diagram showing relationships between groove widths and TCR values under different temperatures. As shown in FIGS. 3A and 3B, when the depth (c) of the first vertical side of the first groove 110 and the depth (f) of the second vertical side of the second groove 120 increase, the TCR value of the resistor 100 exhibits a decreasing trend. When the width (a) of the first transverse side of the first groove 110 and the width (d) of the second transverse side of the second groove 120 are increased, the TCR value may decrease to a negative value. However, a lower TCR value is not necessarily better, and an optimal condition is achieved when the TCR value approaches zero. Therefore, according to the present embodiment, by finely adjusting the sizes and ratios of the depths (c, f) and the widths (a, d) of the above-mentioned grooves, the TCR value of the resistor may approach zero, thereby obtaining an optimal TCR value and reducing current measurement errors caused by temperature differences.

Significant temperature differences are often generated between two ends of power conductive bars (bus bars) connected to the resistor 100 due to different heat dissipation conditions. In an actual application of a power system, a module having a temperature difference of 17°C. may occur. Taking such module as Example 1, when the resistive sheet 103 is made of a copper-manganese-nickel (CuMnNi) alloy material or a copper-manganese-tin (CuMnSn) alloy material (having a thermoelectromotive force coefficient of approximately 0.6 µV/°C), the temperature difference of 17°C. may generate an error of approximately 0.6 × 17 = 10.2 µV under a non-energized state. Errors caused by a plurality of shunt resistors having different resistance values of the resistive sheet 103 are recorded in Table 1 below.

**Table 1**

| | | | |
|---|---|---|---|
| Resistance value | 25µΩ | 50µΩ | 100µΩ |
| Current error | 408 mA | 204 mA | 102 mA |

According to different application conditions, the present invention may compensate for the temperature difference by adjusting the dimensions of the first groove 110 and the second groove 120. In one embodiment, for example, the parameters may be configured as follows. For the first groove 110: a = 10, b = 6, and a depth c = 2. For the second groove 120: d = 2 or 5, e = 6, and a depth f = 3. Through the above-described asymmetric dimensional design, an effective temperature difference between the first detection point 190 and the second detection point 290 on the resistor 100 in an actual product may approach 0°C., thereby significantly improving the measurement accuracy of the product under a high-temperature-difference condition.

Taking the resistor 100 as Example 2, parameters a and d are set to 25 mm, and b and e are set to 6 mm. However, the groove depths thereof are configured in an asymmetric manner, where c = 2 mm and f = 4 mm. When a current of, for example, 1200 A is applied to the resistor 100, due to the depth difference between c and f, the remaining effective conductive cross-sections at bottom portions of the grooves of the first conductive sheet 101 and the second conductive sheet 102 are different, thereby actively generating a temperature difference of 17.2°C. between the first detection point 190 and the second detection point 290. Actual experimental temperature data are recorded in Table 2 below.

**Table 2**

| Location | First detection point 190 | Second detection point 290 |
|---|---|---|
| Temperature (°C) | 162.5 | 179.7 |
| ΔT | 17.2 | |

Such a resistor 100 may be applied to a battery module that generates a temperature difference of 17°C., such that the resistor 100 of the battery module exhibits a temperature difference of 0.2°C. during actual application. Therefore, according to an embodiment of the present invention, a temperature differences caused by an external environment may be compensated for by adjusting the groove depths, thereby ensuring measurement accuracy.

Based on other experiments, actual current-withstand data are recorded in Table 3 below.

**Table 3**

| | | | |
|---|---|---|---|
| depth c (mm) | 0 | 2 | 4 |
| Rated current(A) | 1360 | 1345 | 1150 |
| Δ Current | 100% | 99% | 85% |

According to the experimental data shown in Table 3, when the first conductive sheet 101 is not provided with a groove (c = 0), its rated current is 1360 A. When a non-through groove (depth c = 2 mm) is employed, the rated current decreases only slightly to 1345 A, substantially maintaining approximately 99% of the current-carrying capacity of the original conductive sheet. In contrast, if the groove is replaced with a through-hole (i.e., c = 4 mm, completely penetrating the conductive sheet), the rated current significantly decreases to 1150 A, with its relative current-carrying capacity dropping to only about 85%. These data demonstrate that the current-withstand performance of the non-through groove is significantly superior to that of the conventional through-hole.

As described above, according to an embodiment of the present invention, the resistor 100 is a shunt resistor with an adjustable temperature coefficient of resistance. Through an asymmetrical design featuring non-through grooves, the current density at a sampling location is actively regulated, and the temperature difference between two ends of the shunt resistor is adjusted, thereby effectively reducing the temperature coefficient of resistance (TCR) and suppressing the influence of thermal electromotive force (thermal EMF) on measurement accuracy, thereby significantly improving the precision of dynamic current measurement. The first groove 110 and the second groove 120 are configured as non-through structures such that the conductive sheets maintain a partial thickness at the locations of the grooves. Compared to the conventional through-hole technology, this configuration reduces TCR and exhibits superior current-withstand performance. In addition, the first detection point 190 and the second detection point 290 are disposed between the two grooves, and on a projection plane along a main current direction (D1), the detection points are located within projected areas of the grooves to optimize sampling results.

In another embodiment, instead of employing grooves, an asymmetric boss structure (extension portions) may be utilized. By configuring the extension portions to have different lengths, a temperature difference between two locations of the resistive element 103 may be adjusted, thereby achieving the effect of regulating the thermal electromotive force (thermal EMF) and more accurately reflecting the actual current value. This is described in more detail below.

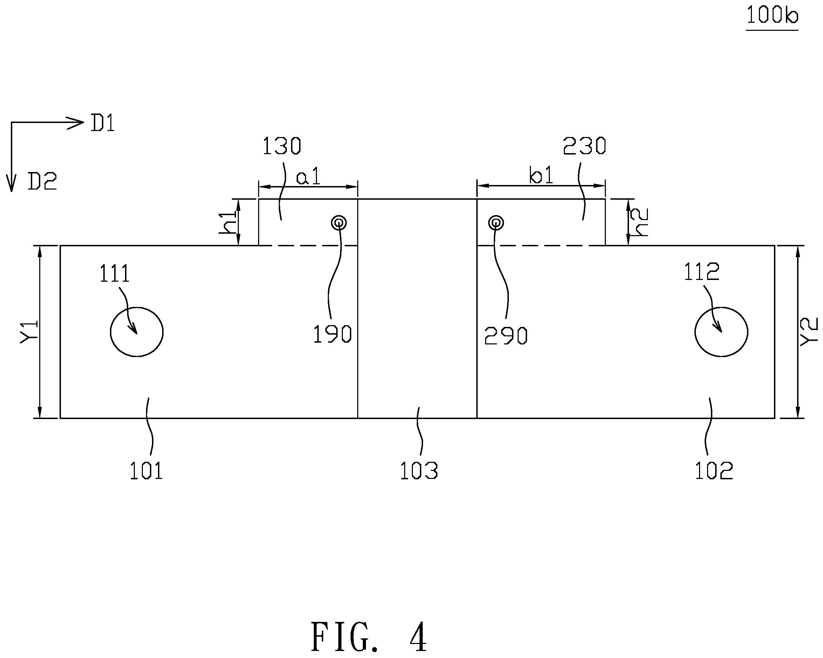

FIG. 4 is a top view of a resistor according to another embodiment of the present invention. As shown in FIG. 4, in another embodiment of the present invention, a resistor 100b is provided. The embodiment of FIG. 4 is similar to the embodiment of FIG. 2A. Therefore, identical elements are denoted by the same reference numerals, and related descriptions thereof are omitted. At least one difference therebetween is described below. The resistor 100b comprises a first conductive sheet 101, a second conductive sheet 102, and a resistive sheet 103 disposed between the first conductive sheet 101 and the second conductive sheet 102, wherein the first conductive sheet 101 and the second conductive sheet 102 are connected via the resistive sheet 103. The resistor 100b further comprises a first extension portion 130 and a second extension portion 230.

The first extension portion 130 projects outward from a first side of the first conductive sheet 101. The second extension portion 230 projects outward from a first side of the second conductive sheet 102. The projection direction of the second extension portion 230 is identical to a projection direction of the first extension portion 130; that is, the first extension portion 130 and the second extension portion 230 extend substantially parallel to each other or in the same direction toward the same side of the resistor 100b. Preferably, the resistive sheet 103 extends toward the first extension portion 130 and the second extension portion 230, such that the resistive sheet 103 further extends into a space between the first extension portion 130 and the second extension portion 230. In the present embodiment, the first detection point 190 is disposed on or electrically connected to the first extension portion 130, and the second detection point 290 is disposed on or electrically connected to the second extension portion 230. A measuring device may stably acquire voltage or current signals across the resistive sheet 103 through the first detection point 190 and the second detection point 290.

In one embodiment, the first extension portion 130 and the second extension portion 230 may be rectangular. The first extension portion 130 comprises a first longitudinal side extending along the first direction D1 (with a length denoted as a1) and a first transverse side extending along the second direction D2 (with a width denoted as h1). The second extension portion 230 comprises a second longitudinal side extending along the first direction D1 (with a length denoted as b1) and a second transverse side extending along the second direction D2 (with a width denoted as h2). If a width of the first conductive sheet 101 is denoted as Y1 and a width of the second conductive sheet 102 is denoted as Y2, in one embodiment, the following conditions are satisfied: Y1 = Y2, h1 = h2, and h1 < Y1. Furthermore, when current flows from the first conductive sheet 101 toward the second conductive sheet 102, the lengths of the longitudinal sides of the two extension portions satisfy the relationship of a1 < b1.

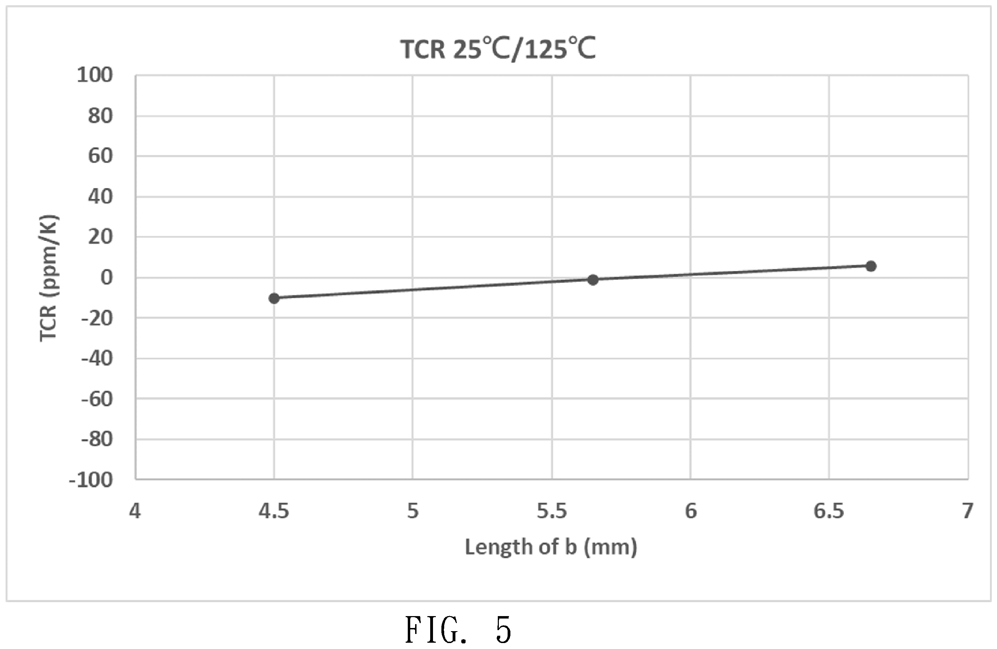

FIG. 5 is a curve diagram showing the relationship between different longitudinal side lengths and TCR values based on experimental data the embodiment of FIG. 4. As shown in FIG. 5, when the length a1 of the first longitudinal side of the first extension portion 130 is fixed at 4.5 mm, and the length b1 of the second longitudinal side of the second extension portion 230 is gradually reduced from 6.5 mm, the TCR value of the resistor 100b decreases accordingly. Therefore, by reducing the length of b1, the TCR value of the resistor 100b can eventually approach zero.

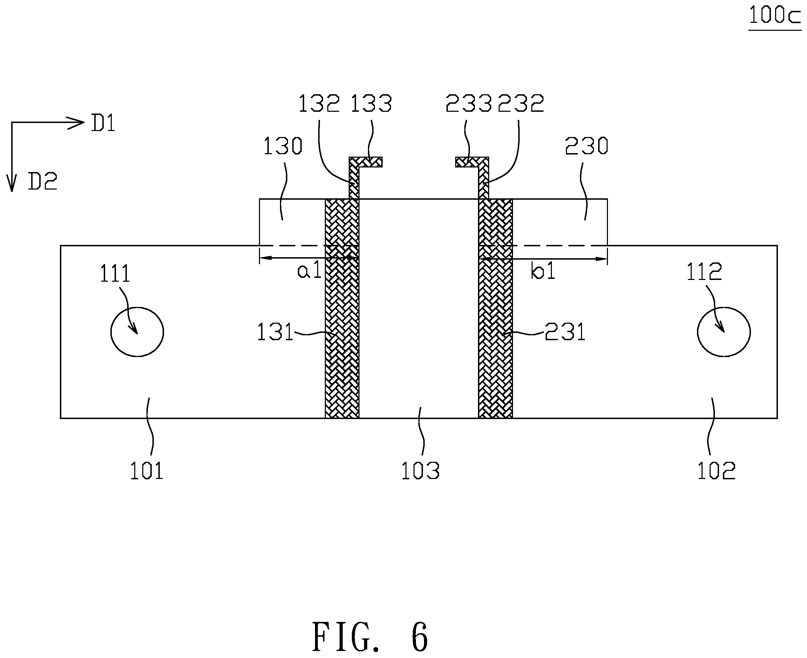

FIG. 6 is a top view of a resistor according to another embodiment of the present invention. As shown in FIG. 6, the resistor 100c further comprises a first sampling line 131 and a second sampling line 231. The first sampling line 131 is attached to the first conductive sheet 101, extends to the first extension portion 130, and is proximate to the resistive sheet 103. The second sampling line 231 is attached to the second conductive sheet 102, extends to the second extension portion 230, and is proximate to the resistive sheet 103. The first sampling line 131 and the second sampling line 231 may be copper foils, copper strips, or conductive sheets, and are preferably soldered onto the first conductive sheet 101 and the second conductive sheet 102 with solder.

The first sampling line 131 comprises a first projecting portion 132. The first projecting portion 132 extends and projects from a first side (right side) of a body of the first sampling line 131 and further projects beyond the first extension portion 130, wherein the first side of the body of the first sampling line 131 is proximate to a left side of the resistive sheet 103. The second sampling line 231 comprises a second projecting portion 232. The second projecting portion 232 extends and projects from a second side (left side) of a body of the second sampling line 231 and further projects beyond the second extension portion 230, wherein the second side of the body of the second sampling line 231 is proximate to a right side of the resistive sheet 103. In one embodiment, the first projecting portion 132 may directly serve as the first detection point 190, and the second projecting portion 232 may serve as the second detection point 290. In one embodiment, the first detection point 190 is located on the first projecting portion 132, and the second detection point 290 is located on the second projecting portion 232.

In one embodiment, the first sampling line 131 may further comprise a first opposing portion 133, which extends from a free end of the first projecting portion 132 toward the second projecting portion 232, wherein the first opposing portion 133 serves as the first detection point 190. The second sampling line 231 may further comprise a second opposing portion 233, which extends from a free end of the second projecting portion 232 toward the first projecting portion 132, wherein the second opposing portion 233 serves as the second detection point 290. In one embodiment, the first detection point 190 is located on the first opposing portion 133, and the second detection point 290 is located on the second opposing portion 233.

As shown in FIG. 6, in one embodiment, a width of the first projecting portion 132 is smaller than a width of the body of the first sampling line 131, wherein the body is attached to the first conductive sheet 101 and the second conductive sheet 102. Furthermore, a second side (left side) of the first sampling line 131 away from the resistive sheet 103 is not formed with a projecting portion, and the first side of the first sampling line 131 is opposite to the second side of the first sampling line 131. Similarly, a first side (right side) of the second sampling line 231 away from the resistive sheet 103 is not formed with a projecting portion, and the first side of the second sampling line 231 is opposite to the second side of the second sampling line 231.

**Table 4**

| PAD offset (mm) | | R25 | TCR(ppm/K) | | |
|---|---|---|---|---|---|
| X | Y | µΩ | 125 | 75 | -40 |
| 0 | 0 | 25.07 | 9.23 | 7.50 | 22.50 |
| 0.3 | 0 | 25.08 | 11.45 | 9.70 | 24.64 |
| -0.3 | 0 | 25.08 | 11.43 | 9.68 | 24.62 |
| 0 | 0.3 | 25.05 | 7.13 | 5.40 | 20.41 |
| 0 | -0.3 | 25.10 | 14.63 | 12.91 | 27.90 |
| Offset-induced errors | | ΔR% MAX | ΔTCR MAX | | |
| | | 0.20% | 7.500 | 7.508 | 7.490 |

**Table 5**

| PAD offset (mm) | | R25 | TCR(ppm/K) | | |
|---|---|---|---|---|---|
| X | Y | µΩ | 125 | 75 | -40 |
| 0 | 0 | 25.04 | 5.28 | 3.53 | 18.51 |
| 0.3 | 0 | 25.06 | 8.60 | 6.84 | 21.77 |
| -0.3 | 0 | 25.06 | 8.65 | 6.89 | 21.82 |
| 0 | 0.3 | 25.04 | 5.36 | 3.61 | 18.59 |
| 0 | -0.3 | 25.05 | 6.54 | 4.80 | 19.76 |
| Offset-induced errors | | ΔR% MAX | ΔTCR MAX | | |
| | | 0.08% | 3.367 | 3.361 | 3.313 |

In the attachment process of the first sampling line 131 and the second sampling line 231 (PAD), positional offsets in a horizontal plane (X-Y direction) may occur, leading to deviations in the resistance value and the temperature coefficient of resistance (TCR). The layout shapes of the first sampling line 131 and the second sampling line 231 of the present embodiment can effectively reduce the resistance and TCR errors induced by such positional offsets. As shown in Table 4 and Table 5, compared to the prior art, after adopting the structure of the sampling lines of the present embodiment, the maximum resistance deviation (ΔR% MAX) is reduced from 0.20% to 0.08%. Meanwhile, the maximum deviation of the temperature coefficient of resistance (ΔTCR MAX) is also reduced, for example, from approximately 7.5 to approximately 3.3. According to the foregoing measured data, the present embodiment can significantly suppress the deviations in resistance value and TCR caused by positional offsets of the sampling lines during the attachment process.

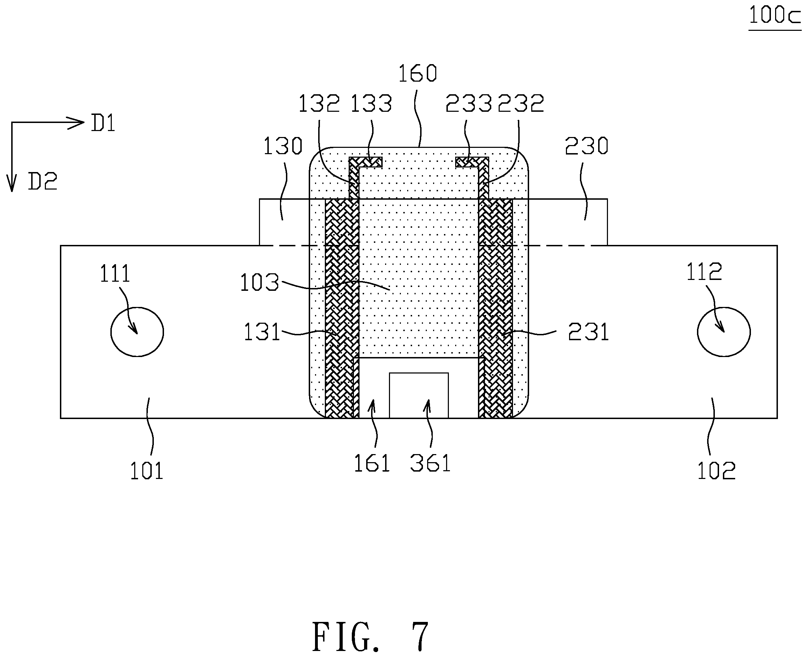

When performing resistance adjustment for the resistor 100, a first correction of the resistance value may be performed by thinning the resistive sheet 103. However, resistance errors may still occur after the resistor 100c is manufactured. FIG. 7 is a top view of a resistor according to another embodiment of the present invention. As shown in FIG. 7, the resistor 100c may further comprise an assembled circuit board 160. To illustrate the relationship between the assembled circuit board 160 and the first sampling line 131 and the second sampling line 231, the assembled circuit board 160 is shown as translucent so that the first sampling line 131 and the second sampling line 231 can be seen. The assembled circuit board 160 is disposed on the first sampling line 131 and the second sampling line 231 and is electrically connected to the first sampling line 131 and the second sampling line 231, thereby establishing electrical communication with the first detection point 190 and the second detection point 290. The assembled circuit board 160 defines an opening 161 at a location corresponding to a portion of the resistive sheet 103 to expose the resistive sheet 103. By providing the opening 161 in the assembled circuit board 160, a portion of the resistive sheet 103 is exposed, such that a trim cut 361 for adjusting resistance can be formed in the exposed portion of the resistive sheet 103 to perform a second resistance correction, thereby achieving more precise resistance calibration. It should be noted that performing the second resistance correction with the assembled circuit board 160 already mounted provides calibration accuracy superior to a method in which the resistance is adjusted before installing the assembled circuit board 160. This is because fine-tuning in the presence of the assembled circuit board 160 allows for simultaneous measurement and compensation of parasitic factors, such as additional resistance introduced during the installation process, ensuring a more accurate calibrated value. In one embodiment, the opening 161 of the assembled circuit board 160, and the first projecting portion 132 and the second projecting portion 232 are respectively located on two opposite sides of the resistor 100c.

In summary, according to the present invention, each of the first conductive sheet 101 and the second conductive sheet 102 is provided with at least one volume-changing structure, such as a non-through groove or an asymmetrical extension portion. The volume-changing structure does not have an opening on a projection plane in a top view, such that current can pass entirely or without interruption through the projection plane of the volume-changing structure, thereby regulating the current density distribution and the temperature difference between sampling points.

A resistor according to an embodiment of the present invention can achieve at least one of the effects of regulating the temperature coefficient of resistance (TCR) and suppressing thermal electromotive force (thermal EMF) through the non-through grooves or asymmetrical extension portions serving as the volume-changing structures. Compared to the conventional through-holes, the resistor according to an embodiment of the present invention further maintains excellent current-withstand performance. In another embodiment, the novel layout of the sampling lines disclosed herein can significantly suppress errors induced by positional offsets during the manufacturing process. In yet another embodiment, the opening 161 of the assembled circuit board 160 allows for resistance correction after assembly is completed, thereby ensuring high-precision measurement.

## Claims

1. A resistor comprising:
- a first conductive sheet defining a first groove, wherein the first conductive sheet forms a bottom surface of the first groove such that the first groove is configured as a non-through groove;
- a second conductive sheet defining a second groove, wherein the second conductive sheet forms a bottom surface of the second groove such that the second groove is configured as a non-through groove;
- a resistive sheet disposed between the first and second conductive sheets;
- a first detection point formed on the first conductive sheet; and
- a second detection point formed on the second conductive sheet.

2. The resistor according to claim 1, wherein:
- the first conductive sheet is plate-shaped;
- the first groove is a rectangular groove and comprises:
- a first longitudinal side (b) extending along a first direction from the first conductive sheet toward the second conductive sheet;
- a first transverse side (a) extending along a second direction perpendicular to the first direction; and
- a first vertical side (c) recessed inward from a surface of the first conductive sheet and perpendicular to the first and second directions.

3. The resistor according to claim 2, wherein:
- the second conductive sheet is plate-shaped;
- the second groove is a rectangular groove and comprises:
- a second longitudinal side (e) extending along the first direction;
- a second transverse side (d) extending along the second direction; and
- a second vertical side (f) recessed inward from a surface of the second conductive sheet and perpendicular to the first and second directions.

4. The resistor according to claim 3, wherein:
- a width of the first transverse side is denoted as a;
- a length of the first longitudinal side is denoted as b;
- a depth of the first vertical side is denoted as c; and
- a > b > c.

5. The resistor according to claim 4, wherein:
- a width of the second transverse side is denoted as d;
- a length of the second longitudinal side is denoted as e;
- a depth of the second vertical side is denoted as f; and
d > e > f.

6. The resistor according to claim 5, wherein:
- a thickness of the first conductive sheet and the second conductive sheet is denoted as h;
- h > c;
- h > f;
- h - c > 0; and
- h - f > 1 mm.

7. The resistor according to claim 3, wherein:
a width of the first transverse side is denoted as a, a length of the first longitudinal side is denoted as b, a depth of the first vertical side is denoted as c, a width of the second transverse side is denoted as d, a length of the second longitudinal side is denoted as e, and a depth of the second vertical side is denoted as f, wherein a = d, b = e, and f ≠ c.

8. The resistor according to claim 1, wherein:
- the first groove is formed recessed inward from a first surface of the first conductive sheet, such that the first conductive sheet has a smaller effective conductive cross-section at a location of the first groove compared to locations of remaining portions of the first conductive sheet;
- the second groove is formed recessed inward from a first surface of the second conductive sheet, such that the second conductive sheet has a smaller effective conductive cross-section at a location of the second groove compared to locations of remaining portions of the second conductive sheet; and
- the first detection point and the second detection point are located between the first groove and the second groove.

9. A resistor comprising:
- a first conductive sheet;
- a second conductive sheet;
- a resistive sheet disposed between the first and second conductive sheets;
- a first extension portion protruding from a first side of the first conductive sheet;
- a second extension portion protruding from a first side of the second conductive sheet, wherein a protrusion direction of the second extension portion is identical to a protrusion direction of the first extension portion;
- a first detection point electrically connected to the first extension portion; and
- a second detection point electrically connected to the second extension portion,
- wherein the resistive sheet preferably further extends between the first extension portion and the second extension portion.

10. The resistor according to claim 9, wherein:
- the first conductive sheet is plate-shaped;
- the first extension portion is rectangular and comprises:
- a first longitudinal side (a1) extending along a first direction from the first conductive sheet toward the second conductive sheet; and
- a first transverse side (h1) extending along a second direction perpendicular to the first direction;
- the second conductive sheet is plate-shaped;
- the second extension portion is rectangular and comprises:
- a second longitudinal side (b1) extending along the first direction from the first conductive sheet toward the second conductive sheet; and
- a second transverse side (h2) extending along the second direction perpendicular to the first direction.

11. The resistor according to claim 10, wherein:
- a length of the first longitudinal side is denoted as a1;
- a length of the second longitudinal side is denoted as b1;
- a width of the first transverse side is denoted as h1;
- a width of the second transverse side is denoted as h2, wherein h1 = h2;
- a width of the first conductive sheet is denoted as Y1;
- a width of the second conductive sheet is denoted as Y2, wherein Y1 = Y2; and
h1 < Y1.
- wherein preferably a1 < b1 when current flows from the first conductive sheet toward the second conductive sheet.

12. The resistor according to claim 11, further comprising:
- a first sampling line attached to the first conductive sheet and extending to the first extension portion, and adjacent to the resistive sheet;
- a second sampling line attached to the second conductive sheet and extending to the second extension portion, and adjacent to the resistive sheet;
wherein:
-- the first sampling line comprises a first protruding portion extending from a side of the first sampling line proximate to the resistive sheet and further protruding beyond the first extension portion, and the first protruding portion serves as the first detection point; and
-- the second sampling line comprises a second protruding portion extending from a side of the second sampling line proximate to the resistive sheet and further protruding beyond the second extension portion, and the second protruding portion serves as the second detection point.

13. The resistor according to claim 11, wherein the first sampling line comprises:
- a first protruding portion extending from a side of the first sampling line proximate to the resistive sheet and further protruding beyond the first extension portion; and
- a first opposing portion extending from a free end of the first protruding portion toward the second protruding portion, wherein the first opposing portion serves as the first detection point;
the second sampling line comprises:
- a second protruding portion extending from a side of the second sampling line proximate to the resistive sheet and further protruding beyond the second extension portion; and
- a second opposing portion extending from a free end of the second protruding portion toward the first protruding portion, wherein the second opposing portion serves as the second detection point.

14. The resistor according to claim 12 or 13, further comprising an assembled circuit board, wherein:
- the assembled circuit board is disposed on the first sampling line and the second sampling line and is electrically connected to the first detection point and the second detection point;
- the assembled circuit board defines an opening at a position corresponding to a portion of the resistive sheet so as to expose the resistive sheet; and
the exposed portion of the resistive sheet is cut to form a trimming cut for resistance adjustment.

15. The resistor according to claim 12 or 13, wherein:
- no protruding portion is formed on a side of the first sampling line away from the resistive sheet; and
- no protruding portion is formed on a side of the second sampling line away from the resistive sheet.
